# DEMANDE DE BREVET EUROPEEN

(11) **EP 1 035 571 A1**
(43) Date de publication de la demande: **13.09.2000**
(21) Numéro de dépôt: 00410026.9
(22) Date de dépôt: 10.03.2000
(51) Int. Cl.: H01L 21/331

(54) **Procédé de fabrication d'un transistor bipolaire**

(30) Priorité: 12.03.1999 FR 9903260
(71) Demandeur: STMicroelectronics S.A., 94250 Gentilly (FR); FRANCE TELECOM, 75015 Paris (FR)
(72) Inventeur: Gris, Yvon, 38210 Tullins (FR); Troillard, Germaine, 38660 Le Touvet (FR)
(74) Mandataire: de Beaumont, Michel

(57) **Abrégé**

L'invention concerne un procédé de fabrication d'un transistor bipolaire dans un substrat semiconducteur (11) de type N, comprenant les étapes consistant à déposer une première couche (13) de silicium polycristallin de contact de base et la doper ; déposer une deuxième couche (14) d'oxyde de silicium ; former dans les première et deuxième couches une ouverture (W) ; effectuer un recuit pour former une troisième couche mince d'oxyde (16) et durcir la deuxième couche d'oxyde ; implanter un dopant de type P ; déposer une quatrième couche (18) de nitrure de silicium ; déposer une cinquième couche (19) d'oxyde de silicium et la graver ; graver de façon anisotrope les cinquième, quatrième et troisième couches ; procéder à des nettoyages pendant lesquels la cinquième couche est regravée et prend un profil évasé ; déposer une sixième couche (20) de silicium polycristallin ; et implanter un dopant de type N.

## Description

La présente invention concerne la fabrication de transistors bipolaires dans des circuits intégrés. Plus particulièrement, la présente invention concerne la formation des régions de base et d'émetteur d'un transistor bipolaire dans une technologie BICMOS.

On considérera des procédés de fabrication de transistors bipolaires qui prévoient de délimiter des zones actives sur un substrat semiconducteur, de déposer une couche de silicium polycristallin de contact de base revêtue d'une couche d'oxyde de silicium, d'ouvrir une zone de base/émetteur, de réaliser des espaceurs sur les parois de l'ouverture, et de déposer une couche de silicium polycristallin de contact d'émetteur. Dans le cadre de ces procédés, on s'intéresse plus particulièrement ici à la formation des espaceurs.

Dans divers procédés classiques, on utilise des espaceurs en oxyde, en nitrure, ou en nitrure/silicium polycristallin. Chacun de ces procédés présente des avantages et des inconvénients. On va d'abord décrire en détail un procédé dans lequel on utilise des espaceurs composites en nitrure/silicium polycristallin pour faire ressortir leurs avantages et leurs inconvénients. On mentionnera ensuite brièvement les avantages et les inconvénients d'autres types d'espaceurs connus.

### Espaceurs en nitrure/silicium polycristallin

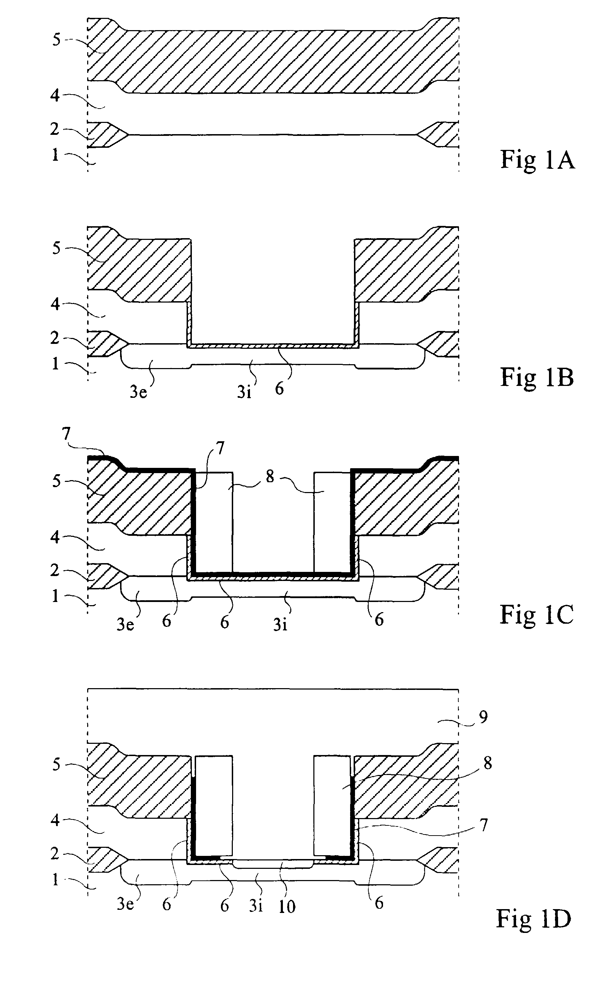

Comme l'illustre la figure 1A, les premières étapes d'un procédé de fabrication de transistor bipolaire consistent à définir à la surface d'un substrat semiconducteur 1, typiquement en silicium, des zones actives délimitées par des zones d'oxyde de champ 2. Ensuite, sont déposées successivement une couche 4 de silicium polycristallin, destinée à former le contact de base, et une couche 5 isolante, typiquement en oxyde de silicium.

Aux étapes suivantes, illustrées en figure 1B, on grave les couches 5 et 4 de façon à exposer une partie sensiblement centrale de la zone active. On effectue ensuite un recuit qui provoque notamment la formation d'une couche 6 d'oxyde de silicium au fond de la fenêtre et sur la surface latérale de la couche de silicium polycristallin 4. On implante un dopant d'un premier type de conductivité, par exemple de type P, typiquement du bore, afin de former la base 3i du dispositif bipolaire. On a aussi représenté une zone de contact de base 3e résultant d'une diffusion des dopants contenus dans la couche de silicium polycristallin 4.

Aux étapes suivantes, illustrées en figure 1C, on réalise des espaceurs. Pour cela, on dépose de façon conforme une couche 7 de nitrure de silicium. Ensuite, on dépose et on grave une couche de silicium polycristallin de façon à former des espaceurs 8 tels que représentés en figure 1C.

Aux étapes suivantes, illustrées en figure 1D, on élimine la couche 7 de nitrure de silicium partout où elle n'est pas protégée par les espaceurs 8, et on nettoie le fond de la fenêtre afin d'exposer la région de base 3. Enfin, on dépose une couche 9 de contact d'émetteur, typiquement en silicium polycristallin. La couche 9 subit ensuite une implantation d'un dopant de type N qui est amené à diffuser pour former une région d'émetteur 10.

On a ainsi formé une jonction base/émetteur entre une région d'émetteur 10 et une région de base 3, la distance entre les contacts de base et d'émetteur étant définie par des espaceurs composites constitués d'oxyde thermique 6, de nitrure de silicium 7 et de silicium polycristallin 8.

On voit bien en considérant la figure 1D les fonctions que doit remplir l'espaceur et les qualités qu'il doit avoir.
1) L'espaceur doit assurer un bon isolement entre les couches de silicium polycristallin 4 et 9. Cet isolement est essentiellement assuré par la couche de nitrure 7. Toutefois, compte tenu de la très faible épaisseur de la couche 7, et des propriétés de gravure du nitrure de silicium, la couche 7 est surgravée sous le silicium polycristallin 8, comme l'illustre la figure 1D. Cette surgravure entraîne divers inconvénients : la cavité formée sera mal remplie par le silicium polycristallin 9 et elle crée une hétérogénéité qui peut être source de contraintes mécaniques et en tout cas d'un mauvais contrôle du processus de fabrication.
2) La capacité entre les régions de silicium polycristallin de base 4 et d'émetteur 9 doit être aussi faible que possible. En effet, on souhaite généralement que le transistor bipolaire commute rapidement. Ce résultat n'est pas obtenu. En effet, le silicium polycristallin 8 est conducteur et le nitrure de silicium est très mince et présente une constante diélectrique élevée.
3) La distance entre le pied (la zone de contact avec le substrat) du silicium polycristallin 4 et le pied du silicium polycristallin 9, de même que la surface du contact entre le silicium polycristallin 9 et le substrat, doivent être déterminées avec précision et être reproductibles. A priori, les espaceurs de silicium polycristallin ont une forme nette et des bords bien droits. Toutefois, la gravure de la couche d'oxyde 6 n'est pas toujours idéale. En effet, en raison de la mauvaise mouillabilité entre le silicium polycristallin et toute solution de gravure, il peut se former des bulles au fond de la fenêtre, au niveau de l'angle de l'espaceur, ce qui conduit à une mauvaise élimination de la couche 6 en cet emplacement comme l'illustre la figure 1D. De même, le lavage ultérieur à l'eau désionisée, destiné à éliminer les résidus de gravure et l'acide fluorhydrique en excès, ne sera pas parfait. Il peut en résulter des dysfonctionnements du dispositif.
4) L'ouverture délimitée par l'espaceur et dans laquelle pénètre le silicium polycristallin 8 doit de préférence être assez évasée pour faciliter le dopage ultérieur de ce silicium polycristallin par implantation et pour réduire les résistances d'accès. Ce résultat n'est à l'évidence pas obtenu avec les espaceurs de la figure 1D, la gravure anisotrope du silicium polycristallin étant pratiquement verticale.
5) Il ne doit pas exister de contraintes différentielles entre l'espaceur et le substrat sous-jacent. Cet objectif est convenablement satisfait par un espaceur nitrure/silicium polycristallin.

### Espaceurs en nitrure de silicium.

On a également tenté d'utiliser des espaceurs en nitrure. Toutefois, on se heurte à de fortes difficultés technologiques pour réaliser des espaceurs suffisamment épais. Ces espaceurs présentent tous les inconvénients exposés aux points 1) à 4) relatifs aux espaceurs nitrure/silicium polycristallin. En outre, en ce qui concerne le point 5), ils sont généralement source de contraintes différentielles.

### Espaceurs en oxyde de silicium

De simples espaceurs en oxyde de silicium présentent un coin supérieur très arrondi et des flancs légèrement divergents vers l'extérieur. Ils sont donc préférables en ce qui concerne le point 4). Également, en ce qui concerne le point 2), ces espaceurs sont satisfaisants car ils peuvent être relativement épais et la constante diélectrique de Si0₂ est beaucoup plus faible que celle de Si₃N₄.

En ce qui concerne les points 1) et 3), ces espaceurs présentent des inconvénients notables.

En outre lors de la gravure des espaceurs, il se forme à la surface exposée du substrat des polymères à base d'oxyde de silicium. Ces polymères seront difficiles à éliminer. En effet, il n'est pas possible de les laver à l'aide d'acide fluorhydrique car on risquerait alors de surgraver les espaceurs également en oxyde de silicium et donc d'augmenter la largeur de l'ouverture ce qui n'est pas souhaitable.

Surtout en ce qui concerne le point 5), un autre inconvénient des espaceurs en oxyde de silicium réside dans l'apparition de contraintes de dilatation thermique entre l'oxyde et le silicium sous-jacent. Cet inconvénient est notamment souligné dans la demande de brevet EP-A-0746032 de la société Matsushita Electronics Corporation. Ce document, qui préconise l'utilisation d'espaceurs en oxyde ou en nitrure/oxyde pour des transistors MOS d'une structure BICMOS, indique que les problèmes de contraintes thermiques interdisent l'utilisation de tels espaceurs pour les transistors bipolaires et préconise pour ces transistors l'utilisation d'espaceurs composites en nitrure/ silicium polycristallin, ce qui complique beaucoup le procédé de fabrication.

Un objet de la présente invention est de proposer un nouveau procédé de fabrication de transistors bipolaires qui pallie un ou plusieurs des inconvénients des divers procédés connus.

Un autre objet de la présente invention est de proposer un tel procédé qui réduise la résistance de la jonction base-émetteur.

Un autre objet de la présente invention est de proposer un tel procédé qui soit simple à mettre en oeuvre, en particulier dans une technologie BICMOS.

Pour atteindre ces objets, la présente invention prévoit un procédé de fabrication d'un transistor bipolaire dans un substrat semiconducteur d'un premier type de conductivité, comprenant les étapes consistant à déposer une première couche de silicium polycristallin de contact de base et la doper ; déposer une deuxième couche d'oxyde de silicium ; former dans les première et deuxième couches une ouverture ; effectuer un recuit pour former une troisième couche mince d'oxyde et durcir la deuxième couche d'oxyde ; implanter un dopant du deuxième type de conductivité ; déposer une quatrième couche de nitrure de silicium ; déposer une cinquième couche d'oxyde de silicium et la graver ; graver de façon anisotrope les cinquième, quatrième et troisième couches ; procéder à des nettoyages pendant lesquels la cinquième couche est regravée et prend un profil évasé ; déposer une sixième couche de silicium polycristallin ; et implanter un dopant du premier type de conductivité.

Selon un mode de réalisation de la présente invention, l'étape de dopage de la première couche de silicium polycristallin consiste à réaliser une implantation à faible énergie pour concentrer initialement les atomes dopants dans la partie supérieure de la première couche de silicium polycristallin.

Selon un mode de réalisation de la présente invention, les nettoyages comprennent un nettoyage en milieu acide, un nettoyage sous plasma d'oxygène et un nettoyage humide.

Selon un mode de réalisation de la présente invention, la troisième couche mince d'oxyde a une épaisseur de l'ordre de 5 nm.

Selon un mode de réalisation de la présente invention, la quatrième couche de nitrure de silicium a une épaisseur de l'ordre de 30 nm.

Selon un mode de réalisation de la présente invention, la cinquième couche d'oxyde de silicium a une épaisseur de l'ordre de 150 nm.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D représentent en vue en coupe différentes étapes d'un procédé classique de formation de régions de base et d'émetteur d'un transistor bipolaire ; et
les figures 2A à 2F illustrent un procédé de formation de régions de base et d'émetteur d'un transistor bipolaire selon la présente invention.

Par souci de clarté, les mêmes éléments ont été désignés par les mêmes références aux différentes figures. De plus, comme cela est habituel dans la représentation des circuits intégrés les diverses figures ne sont pas tracées à l'échelle.

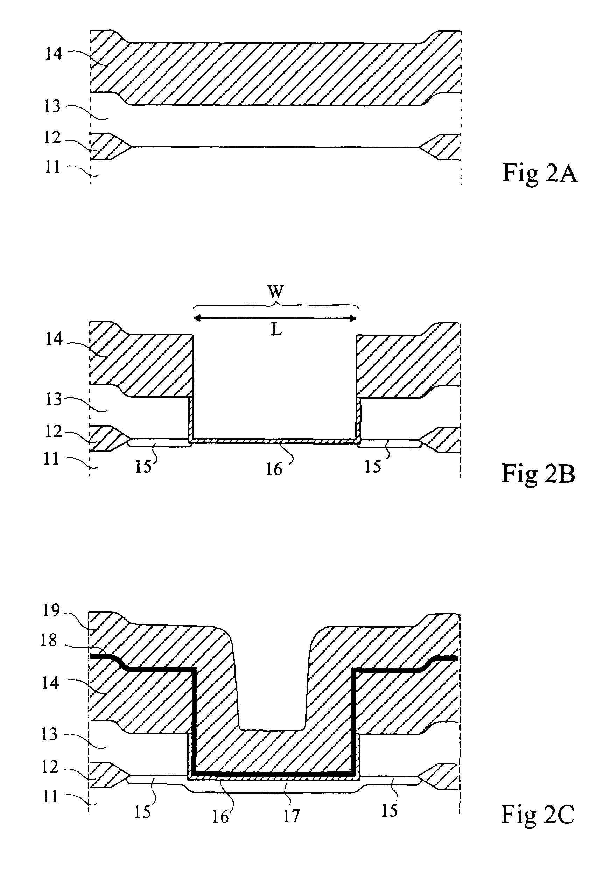

Comme l'illustre la figure 2A, les étapes initiales consistent à délimiter une zone active dans un substrat semiconducteur 11, par exemple en silicium monocristallin, par des zones d'isolement 12. Le substrat peut être une tranche de silicium uniformément dopée, ou une zone épitaxiée et/ou spécifiquement dopée par diffusion/implantation formée sur ou dans un substrat massif. Les zones d'isolement 12 peuvent être des régions du substrat spécifiquement oxydées (procédé LOCOS), des tranchées d'isolement remplies d'oxyde de silicium (procédé BOX), ou analogue. Après la définition des zones actives, on dépose une couche 13 de silicium polycristallin destinée à former les contacts de base. La couche 13 a par exemple une épaisseur de 200 nm. On implante ensuite à la surface du conducteur 13 un dopant d'un premier type de conductivité, par exemple P. Cela est réalisé en implantant du bore à faible énergie, par exemple 15 keV et à une dose de 5.10¹⁵ at./cm² pour que les atomes dopants implantés soient éloignés du substrat et ne diffusent pas dans celui-ci dès le premier recuit. La structure ainsi formée est recouverte d'une couche isolante 14, par exemple une couche d'oxyde de silicium de 300 nm d'épaisseur. La couche 14 pourra être formée par toute technique classique, telle qu'un dépôt chimique en phase vapeur.

Aux étapes suivantes, illustrées en figure 2B, on grave les couches 13 et 14 de façon à former une fenêtre W de largeur L. On effectue alors un recuit thermique d'où il résulte qu'un oxyde thermique 16 croît à la surface du substrat 11 au fond de la fenêtre W et sur les bords exposés de la couche de silicium polycristallin 13. Cet oxyde est très mince et a par exemple une épaisseur de l'ordre de 5 nm.

Ce recuit provoque avantageusement un durcissement de la couche isolante 14 et une diffusion d'une région 15 de type P, de base extrinsèque.

Aux étapes suivantes, illustrées en figure 2C, on forme par implantation à travers l'oxyde thermique mince 16 une région de base 17. La région de base 17 est du même type de conductivité que la couche 13. On dépose ensuite de façon conforme une couche de nitrure de silicium 18. La couche 18 a par exemple une épaisseur de l'ordre de 30 nm. On dépose alors de façon conforme une couche 19 d'oxyde de silicium destinée à la formation des espaceurs et ayant par exemple une épaisseur de l'ordre de 150 nm.

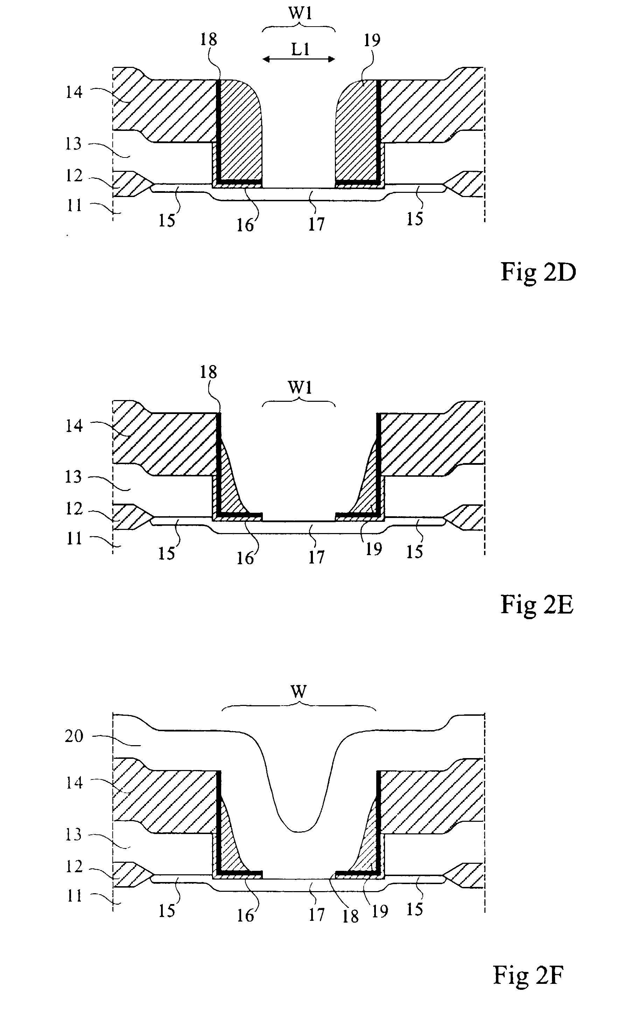

Aux étapes suivantes, illustrées en figure 2D, on grave de façon anisotrope la couche d'oxyde 19 dont il demeure des espaceurs, la couche de nitrure 18 puis la couche d'oxyde thermique 16. Ces gravures sont effectuées successivement dans le même équipement de gravure et s'arrêtent sur la surface du silicium sous-jacent sur une largeur L1, au fond d'une fenêtre W1. La couche d'oxyde thermique 16 étant extrêmement mince, on peut considérer que la dernière gravure est la gravure de la couche de nitrure 18 et ceci est particulièrement favorable car cette gravure est peu susceptible de créer des polymères se déposant sur le silicium. Il faut toutefois éliminer ensuite les polymères susceptibles de s'être formés.

A l'étape suivante, illustrée en figure 2E, on procède à des nettoyages, de préférence en trois temps. Premièrement, un nettoyage humide par des milieux acides en présence d'eau oxygénée. Deuxièmement, un nettoyage sous plasma d'oxygène pour craquer les molécules de polymères. Troisièmement, un nettoyage en présence d'acide fluorhydrique pour éliminer les particules résultant du nettoyage précédent.

Ces nettoyages ont avantageusement pour effet de regraver partiellement les espaceurs formés à partir de la couche 19 sur les parois de la fenêtre W1. La regravure de la couche 19 s'effectue sensiblement sur une épaisseur de 100 nm. Cela conduit à un profil évasé tel qu'illustré en figure 2E dans lequel la couche 19 est sensiblement éliminée de la partie haute des parois verticales de l'ouverture W, c'est-à-dire sensiblement au niveau de la couche isolante 14, et maintenue dans la partie basse de l'ouverture W, c'est-à-dire sensiblement en regard des parois verticales de la couche 13 de contact de base. On notera que, pendant ces nettoyages, la face supérieure de la couche d'oxyde 14 est peu affectée, cette couche ayant été soumise à une opération de durcissement. En gros, elle est six fois moins gravée que la couche d'oxyde 19. C'est là un avantage notable du procédé selon la présente invention.

Aux étapes suivantes, illustrées en figure 2F, on dépose de façon conforme une couche 20 de silicium polycristallin de contact d'émetteur. La couche 20 a par exemple une épaisseur de 250 nm. On implante ensuite à la surface de la couche 20 un dopant d'un deuxième type de conductivité. Dans le cas considéré, cette implantation de type N est effectuée à l'aide d'arsenic à une dose de 10¹⁶ at./cm² sous une énergie de 80 keV. On notera que la couche 20 présente dans la fenêtre W une épaisseur sensiblement constante.

Si l'on reprend les caractéristiques 1) à 5) exposées précédemment auxquelles doit de préférence satisfaire un espaceur, on verra que l'espaceur selon la présente invention présente de nombreux avantages par rapport à l'espaceur composite nitrure/silicium polycristallin.
1) L'isolement entre les deux régions de silicium polycristallin 13 et 20 est assuré, outre par la couche très mince d'oxyde thermique 16, par l'épaisseur de nitrure de silicium, qui n'est affectée par aucune des étapes du procédé et qui n'est pas sujette à surgravure, et par l'épaisseur restante des espaceurs d'oxyde 19.
2) Pour la même raison, la capacité entre les deux régions de silicium polycristallin est réduite.
3) Les cotes sont obtenues avec précision car elles résultent de l'étape de gravure du nitrure 18 illustrée à la figure 2D.
4) Comme on le voit en figure 2F, l'ouverture définie par l'espaceur est évasée, et la couche de silicium polycristallin 20 présente une épaisseur sensiblement constante au-dessus de l'ouverture. Elle comprend notamment une cuvette relativement profonde, ce qui favorise l'obtention d'un dopage régulier du silicium polycristallin par implantation.
5) Enfin, le problème des contraintes résiduelles est résolu grâce à la regravure de l'espaceur d'oxyde qui passe de la forme classique illustrée en figure 2D à la forme évasée selon l'invention illustrée en figures 2E et 2F.

De plus, le procédé de fabrication selon la présente invention est relativement simple à mettre en oeuvre par des techniques classiques et notamment, l'oxyde de silicium présentant une bonne mouillabilité vis-à-vis des produits de nettoyage couramment utilisés, les nettoyages des surfaces de contact sont facilités.

Bien entendu, la présente invention est susceptible de diverses variantes et modifications qui apparaîtront à l'homme de l'art. En particulier, la présente invention a été décrite dans le cas particulier de la réalisation d'un dispositif bipolaire de type PNP, uniquement à titre d'exemple et tout ce qui a été dit s'applique également à la réalisation d'un dispositif de type NPN, pour autant que l'on modifie de façon appropriée les types de conductivité des dopants implantés.

## Revendications

1. Procédé de fabrication d'un transistor bipolaire dans un substrat semiconducteur (11) d'un premier type de conductivité, comprenant les étapes consistant à déposer une première couche (13) de silicium polycristallin de contact de base et la doper, déposer une deuxième couche (14) d'oxyde de silicium, et former dans les première et deuxième couches une ouverture (W), caractérisé en ce qu'il comprend les étapes suivantes :
effectuer un recuit pour former une troisième couche mince d'oxyde (16) et durcir la deuxième couche d'oxyde ;
implanter un dopant du deuxième type de conductivité ;
déposer une quatrième couche (18) de nitrure de silicium ;
déposer une cinquième couche (19) d'oxyde de silicium et la graver;
graver de façon anisotrope les cinquième, quatrième et troisième couches ;
procéder à des nettoyages pendant lesquels la cinquième couche est regravée et prend un profil évasé ;
déposer une sixième couche (20) de silicium polycristallin ; et
implanter un dopant du premier type de conductivité.

2. Procédé selon la revendication 1, caractérisé en ce que l'étape de dopage de la première couche de silicium polycristallin consiste à réaliser une implantation à faible énergie pour concentrer initialement les atomes dopants dans la partie supérieure de la première couche de silicium polycristallin.

3. Procédé selon la revendication 1, caractérisé en ce que les nettoyages comprennent un nettoyage en milieu acide, un nettoyage sous plasma d'oxygène et un nettoyage humide.

4. Procédé selon l'une quelconque des revendications précédentes, caractérisé en ce que la troisième couche mince d'oxyde (16) a une épaisseur de l'ordre de 5 nm.

5. Procédé selon l'une quelconque des revendications précédentes, caractérisé en ce que la quatrième couche de nitrure de silicium (18) a une épaisseur de l'ordre de 30 nm.

6. Procédé selon l'une quelconque des revendications précédentes, caractérisé en ce que la cinquième couche (19) d'oxyde de silicium a une épaisseur de l'ordre de 150 nm.
